# EUROPEAN PATENT APPLICATION

(11) **EP 2 282 336 A2**
(43) Date of publication of application: **09.02.2011**
(21) Application number: 10251083.1
(22) Date of filing: 11.06.2010
(51) Int. Cl.: H01L 23/473

(54) **Base plate with tailored interface**

(30) Priority: 11.06.2009 US 483147
(71) Applicant: Lee, Hsing-Chung, Calabasas, CA 91302 (US); Tandon, Rajiv, San Diego, CA 92129 (US); Remsburg, Ralph, San Diego, CA 92130 (US)
(72) Inventor: Lee, Hsing-Chung, Calabasas, CA 91302 (US); Tandon, Rajiv, San Diego, CA 92129 (US); Remsburg, Ralph, San Diego, CA 92130 (US)
(74) Representative: Johnstone, Helen Margaret

(57) **Abstract**

Base plate apparatus for mounting IGBT modules, the base plate apparatus includes a base plate with a mounting surface and an opposed surface. A tailored coefficient of thermal expansion interface layer is directly bonded to the mounting surface of the base plate and forms a mounting surface for mounting IGBT modules. The interface layer has a coefficient of thermal expansion ranging from approximately 4 ppm/°C to approximately 12 ppm/°C.

## Description

### Field of the Invention

This invention generally relates to a cold plate/base plate for Integrated Gate Bipolar Transistor (IGBT) modules.

### Background of the Invention

Bolt-on Integrated Gate Bipolar Transistor (IGBT) modules are transistor devices formed on silicon substrates for generating high power control and or drive energy. Because of the high power involved, IGBT modules need some form of heat sink or heat conducting structure to conduct the heat away from the module. To this end the IGBT modules are assembled on a heat sink or cooling structure using either a copper base plate or an AlSiC base plate. The standard procedure for assembling an IGBT module on a base plate is to solder one surface of a Direct Bond Copper (DBC) substrate to the base plate and then solder the silicon substrate of the IGBT module to the opposite surface of the DBC substrate.

For high reliability IGBT modules, such as for traction and motor drives, an AlSiC base plate/ cold plate is preferred due to its lower coefficient of thermal expansion (CTE) with respect to the silicon substrate (a CTE of approximately 4 ppm/°C), which minimizes the stress due to repeated thermal cycling. One of the known failure modes that limits the use of copper base plates in high reliability IGBT module applications is the failure of a solder layer between the cold plate/base plate and the DBC substrate, due to the high CTE value (17 ppm/°C) for copper. The high thermal conductivity for copper is therefore not a prime driver for high reliability IGBT modules in the prior art.

It would be highly advantageous, therefore, to remedy the forgoing and other deficiencies inherent in the prior art.

### Summary of the Invention

Briefly, to achieve the desired objects of the instant invention in accordance with a preferred embodiment thereof, provided is a base plate apparatus for mounting IGBT modules. The base plate apparatus includes a base plate with a mounting surface and an opposed surface. A tailored coefficient of thermal expansion interface layer is directly bonded to the mounting surface of the base plate and forms a mounting surface for mounting IGBT modules. The interface layer has a coefficient of thermal expansion ranging from approximately 4 ppm/°C to approximately 12 ppm/°C.

The desired objects of the instant invention are further achieved in accordance with a preferred embodiment of a method thereof, including directly bonding a tailored coefficient of thermal expansion interface layer to a base plate for mounting IGBT modules, the method includes the steps of providing a base plate with a mounting surface and an opposed surface, and forming a tailored coefficient of thermal expansion interface layer on the mounting surface of the base plate by an additive process so that adhesion between the base plate and the tailored coefficient of thermal expansion interface layer produces direct bonding.

The method further includes a step of forming a depression in the mounting surface of the base plate defining the bounds of the thermal expansion interface layer, and forming the thermal expansion interface layer in the depression and directly bonded to the mounting surface of the base plate in the depression. The step of forming a tailored coefficient of thermal expansion interface layer can include sintering a layer of powdered material on the base plate within the depression.

### Brief Description of the Drawings

The foregoing and further and more specific objects and advantages of the instant invention will become readily apparent to those skilled in the art from the following detailed description of a preferred embodiment thereof taken in conjunction with the drawings, in which:
FIG. 1 is a perspective view of a bolt-on Integrated Gate Bipolar Transistor (IGBT) module with a tailored coefficient of thermal expansion interface in accordance with the present invention; and
FIG. 2 is a sectional view in perspective of the bolt-on Integrated Gate Bipolar Transistor (IGBT) module of FIG. 1;
FIG. 3 is an enlarged and simplified partially exploded sectional view of the bolt-on Integrated Gate Bipolar Transistor (IGBT) module of FIG. 1, illustrating the DBC substrate and transistor device substrate;
FIG. 4 is a view similar to FIG. 3 of another embodiment of the tailored coefficient of thermal expansion interface; and
FIG. 5 is a greatly enlarged sectional view of another embodiment of the tailored coefficient of thermal expansion interface.

### Detailed Description of a Preferred Embodiment

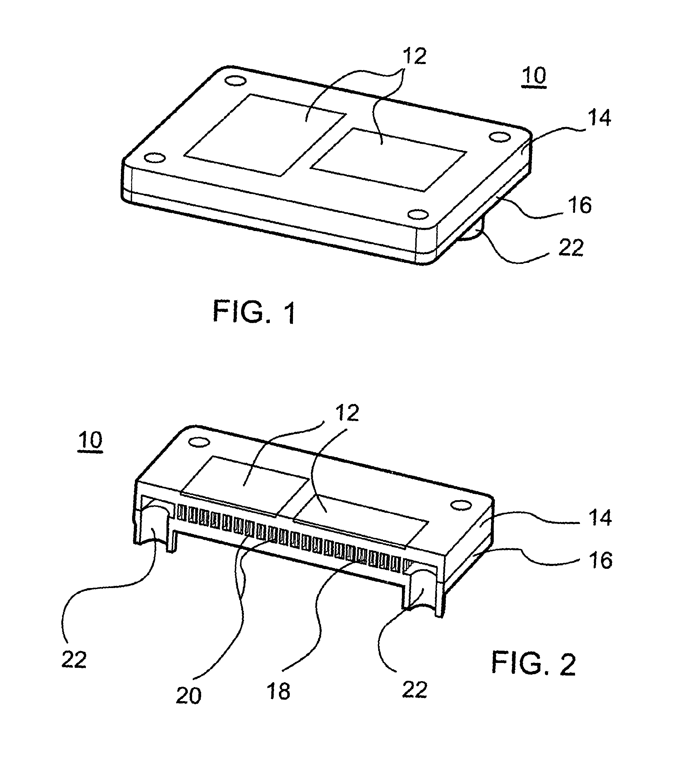

Turning now to the drawings, attention is first directed to FIGS. 1 and 2, which illustrates a cold plate 10 for use with a bolt-on Integrated Gate Bipolar Transistor (IGBT) module. Cold plate 10 includes a tailored coefficient of thermal expansion (CTE) interface 12 in accordance with the present invention. In this specific example, cold plate 10 is formed with an upper section 14 and a lower section 16 that mate to form a coolant cavity 18 therebetween. Upper section 14 is referred to herein as a base plate and includes cooling fins or protrusions 20 formed to extend downwardly into coolant cavity 18. As can be seen best in FIG. 2, lower section 16 has coolant inlet/outlet ducts 22 formed at opposite ends and in fluid communication with coolant cavity 18. As understood by those of skill in the art, a fluid coolant (either liquid or gas) flows through coolant cavity 18 between inlet/outlet ducts 22 and passes around cooling fins or protrusions 20 to absorb and carry heat from base plate 14.

It will of course be understood that cold plate 10 is a specific example of a cold plate commonly used with IGBT modules but other embodiments of cold plates might be used in conjunction with the present invention. Generally, cold plate 10 with upper section (base plate) 14 and lower section 16 is an advanced design feature for larger more expensive devices and a simpler copper base plate (basically a heat sink) might be used in place of cold plate 10. For purposes of this disclosure either embodiment (along with any variations between the two) is considered to come within the definition of a base plate, hereafter designated 14.

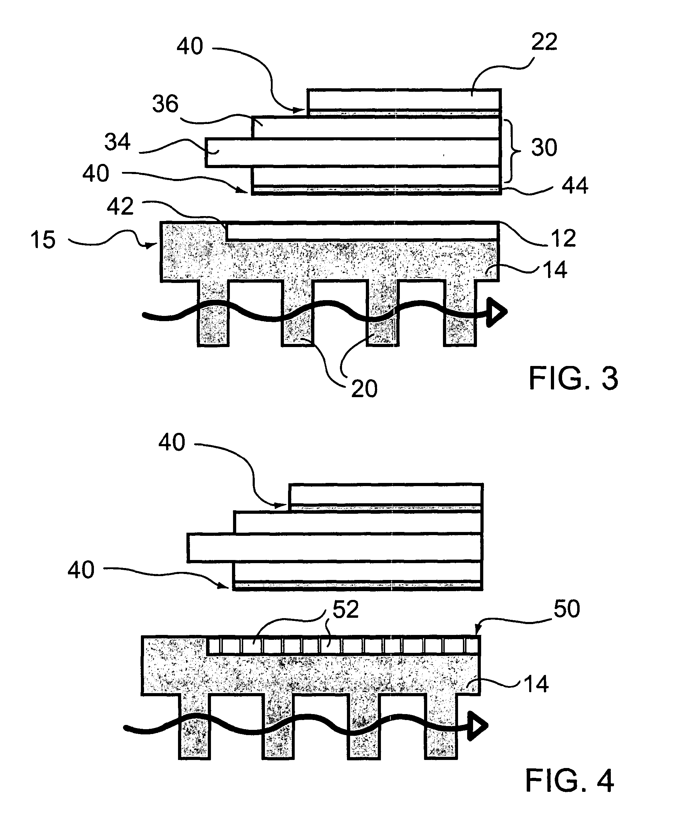

Referring additionally to FIG. 3, an enlarged and simplified sectional view of base plate 14 is illustrated including tailored CTE interface 12 positioned on an upper or mounting surface. For purposes of this disclosure the combination of base plate 14 and CTE interface 12 will be referred to as "base plate apparatus" and is designate 15. A DBC substrate 30 and a transistor device substrate 32 (generally representing an IGBT module) are illustrated in a partially exploded view to show the size and position relative to base plate 14 and CTE interface 12. DBC substrate 30 is a standard device used to attach an IGBT module to a base plate and includes a ceramic layer 34 for insulating the IGBT module from the base plate. Because it is very difficult to attach ceramic layer 34 to base plate 14 and transistor device substrate 32, a copper film 36 is bonded to the upper and lower surfaces of ceramic layer 34 as an attachment or bonding means. It should be noted that copper film 36 is very thin and contributes virtually nothing to the overall coefficient of thermal expansion.

Transistor device substrate 32 (generally representing an IGBT module) is affixed to the upper surface of DBC substrate 30 by a thin layer 40 of solder. Copper film 36 ensures a good bond (i.e. good thermal transfer) between transistor device substrate 32 and ceramic layer 34. Also, copper film 36 on the lower surface of ceramic layer 34 ensures a good bond (i.e. good thermal transfer) between ceramic layer 34 and a base plate 14 through a thin layer 44 of solder. It will be understood that ceramic layer 34 is selected to have a CTE approximately equal to the CTE of transistor device substrate 32 so that no undue stress is applied to transistor device substrate 32 due to repeated thermal cycling. Thus, the combined or resultant CTE of transistor device substrate 32 and DBC substrate 30 is approximately 4 ppm/°C. As explained briefly above, the prior art uses an AlSiC base plate/cold plate with a lower coefficient of thermal expansion (i.e. closer to 4 ppm/°C) to minimize the stress due to repeated thermal cycling.

In a preferred embodiment in accordance with the present invention, base plate 14 is formed of copper. A depression 42 is formed in the upper surface of base plate 14 with an area approximately the size of the area of the lower surface of DBC substrate 30 or the area where DBC substrate 30 is soldered to base plate 14. Tailored CTE interface layer 12 is then formed in depression 42 using material selected from a range of metals, ceramics, and refractory metals which individually or in combination have CTE values ranging from approximately 4 ppm/°C to approximately 12 ppm/°C. Also, the material forming CTE interface layer 12 is preferably selected to have an inherent thermal K value in a range of approximately 100 W/mK to approximately 1000 W/mK. CTE interface layer 12 is formed in depression 42 preferably by an additive process so that there is very good adhesion or bonding therebetween and no braze or solder interface is included between CTE interface layer 12 and base plate 14. Using traditional joining processes, such as soldering and brazing, would subject CTE interface layer 12 to the same failures described above in conjunction with the failure of a solder layer between the cold plate/base plate and the DBC substrate. For purposes of this disclosure the formation of CTE interface layer 12 directly on the surface of base plate 14 with no intermediate structure is referred to as a "direct bond", "directly bonded", or "directly bonding".

It should be understood that depression 42 is provided in the preferred embodiment to enhance the formation of CTE interface layer 12 and to ensure a good bond between base plate 14 and CTE interface layer 12. Also, the depth of depression 42 is preferably the same as the thickness of CTE interface layer 12. However, it will be understood that in different specific applications the depth of depression 42 may be such that CTE interface layer 12 is coplanar (i.e. the same as the thickness of CTE interface layer 12 as illustrated), sub planar, or protruding above the plane of base plate 14. Also, in some specific applications depression 42 may not be incorporated and CTE interface layer 12 may simply be formed on the upper surface of base plate 14. Further, the thickness of CTE interface layer 12 can be constant throughout the entire contact area or it can vary across any given area (e.g. have a bow feature), depending upon the specific base plate 14 and the construction of transistor device substrate 32.

It should be noted that because CTE interface layer 12 is bonded directly to base plate 14, rather than being soldered or brazed, any stress caused by a difference in CTE between base plate 14 and CTE interface layer 12 is simply dissipated in CTE interface layer 12 without stressing the bond therebetween. Also, since the CTE of CTE interface layer 12 is closer to the CTE of DBC substrate 30 stress applied directly to solder layer 44 is greatly reduced or eliminated.

In the formation of CTE interface layer 12, the additive process can be, for example, sintering or spraying using a range of compositions that have an inherent coefficient of thermal expansion ranging from approximately 4 ppm/°C to approximately 12 ppm/°C. Some examples of other additive processes that can be used include electro-deposition, electro-plating, electroless-plating, and similar processes. The thickness typically lies within a range from approximately 0.10 mm to approximately 1.5 mm and preferentially between approximately 0.25 mm and approximately 1.0 mm.

In one specific example of the formation of CTE interface layer 12, a powder based approach is used that involves sintering or co-sintering powder of different compositions on top of base plate 14 or within depression 42 in base plate 14. In another manifestation, multiple layers can be created within CTE interface layer 12 using functionally gradient materials with discretely varying coefficients of thermal expansion in each individual sub-layer. A powder based approach such as spraying can also be used to deposit homogeneous or discretely different layers of varying compositions. In this way CTE interface layer 12 can be formed with a CTE gradient between upper and lower surfaces or with substantially any desired composite CTE.

Discrete layers may be formed independent of base plate 14, and attached during a later stage of the manufacturing process. For example, in order to minimize the CTE mismatch of a 17ppm/K copper base plate 14 and a 4ppm/K ceramic layer 34, a layer having a CTE of 7ppm/K, a layer having a CTE of 10ppm/K, and a layer having a CTE of 13ppm/K, may be manufactured separately, bonded together through sintering, and then attached to base plate 14 immediately before assembly. The advantage can be seen when cold plate assembly 10 is manufactured by a metal injection molding process. The last stage of the metal injection molding process usually involves sintering at an elevated temperature for a period of time. If the discrete CTE-matched layers have also been formed using a metal injection molding process, the "green" (unsintered) layers may be placed in physical proximity and with slight pressure against a "green" base plate 14 and sintered simultaneously. At the end of the sintering process, the three discrete layers and base plate 14 will become one unit. It will be understood that more or fewer discrete layers may be included if desired. Using variations of the metal injection molding process and custom sintering profiles, the layers may blend to form a homogeneous structure that has a low CTE at the semiconductor attachment surface and gradually changes to a higher CTE internally to match the primary metal constituent, thus minimizing the CTE mismatch, while simultaneously eliminating bonding layers.

Turning to FIG. 4, another embodiment of a base plate 14 with a tailored coefficient of thermal expansion interface layer, designated 50, is illustrated. In this embodiment, CTE layer 50 is formed as an aggregate of cells 52 with an xy dimension selected to lie in a range of approximately 1x1 mm to approximately 10x10 mm. Cells 52 are designed to minimize stress caused due to thermal cycling mismatch that can lead to failure of the stress compensating layer (i.e. CTE layer 50). The spacing between cells 52 can range from approximately 200 micrometers to approximately 1000 micrometers.

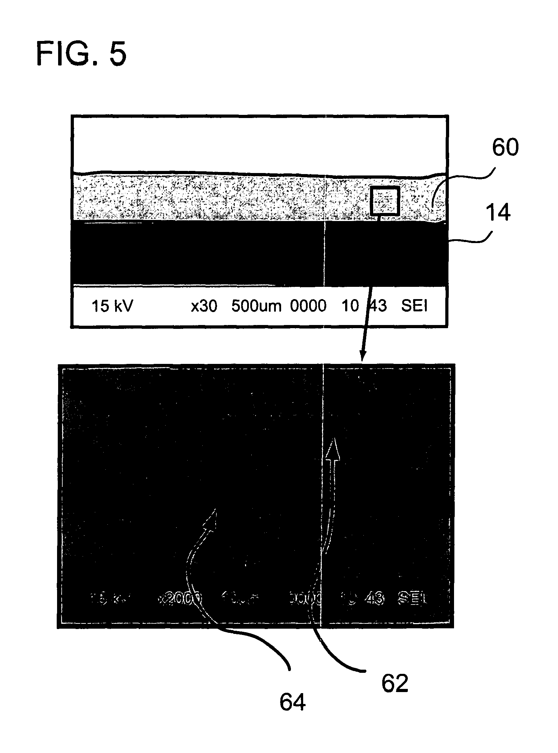

Turning to FIG. 5 another embodiment of a base plate 14 with a tailored coefficient of thermal expansion interface layer, designated 60, is illustrated. In this embodiment CTE layer 60 includes particles of a first element 62 interspersed in a second element 64. Elements 62 and 64 are selected to provide a metal/metal matrix with very good adhesion to copper base plate 14. Elements 62 and 64 are selected to provide a preferred combined CTE of approximately 7 ppm/°C with a thickness between approximately 0.5 mm to approximately 1 mm. In one specific embodiment, metal coated particles (e.g. cu coated W(Mi-Ti)) particles were purchased from Federal Technology Group, Cleveland Ohio. The company produces metal, ceramic, or other basic particulate powders completely coated with and elemental metal, such as Cu, Ni, Zn, Sn, Fe, or Co and the coverage of each particle is uniform and complete.

It has been found that there is a very small contribution to the overall thermal resistance from the CTE layer. Also, variations of the CTE layer thickness were found to have very little overall effect with thicker layers adding only very small thermal resistance to the overall stack-up resistance.

Thus, a new and improved cold plate/base plate with tailored interface for IGBT modules has been disclosed. Specifically, an improved and tailored CTE layer is formed between the base plate and the DBC substrate that allows the base plate to be formed of copper to substantially improve the thermal conductivity of the base plate. Further, the CTE layer is formed directly on the base plate by an additive process that eliminates the need for a brazed or solder interface between the CTE layer and the base plate. Eliminating the brazed or solder interface substantially eliminates any failures due to repeated thermal cycling.

Various changes and modifications to the embodiments herein chosen for purposes of illustration will readily occur to those skilled in the art. To the extent that such modifications and variations do not depart from the spirit of the invention, they are intended to be included within the scope thereof which is assessed only by a fair interpretation of the following claims.

Having fully described the invention in such clear and concise terms as to enable those skilled in the art to understand and practice the same, the invention claimed is:

## Claims

1. Base plate apparatus for mounting IGBT modules, the base plate apparatus comprising:
a base plate with a mounting surface and an opposed surface;
a tailored coefficient of thermal expansion interface layer directly bonded to the mounting surface of the base plate and forming a mounting surface for mounting IGBT modules, the interface layer having a coefficient of thermal expansion ranging from approximately 4 ppm/°C to approximately 12 ppm/°C.

2. Base plate apparatus as claimed in claim 1 wherein the base plate includes a cold plate.

3. Base plate apparatus as claimed in claim 1 wherein thickness of the thermal expansion interface layer lies within a range from approximately 0.10 mm to approximately 1.5 mm.

4. Base plate apparatus as claimed in claim 1 wherein the thermal expansion interface layer includes at least one of metals, ceramics, and refractory metals which individually or in combination have coefficient of thermal expansion values ranging from approximately 4 ppm/°C to approximately 12 ppm/°C.

5. Base plate apparatus as claimed in claim 1 wherein the thermal expansion interface layer includes at least one layer of sintered powder.

6. Base plate apparatus as claimed in claim 5 wherein the sintered powder includes a plurality of different compositions.

7. Base plate apparatus as claimed in claim 5 wherein the base plate includes a metal injection molded base plate with a mounting surface and an opposed surface and the interface layer includes a tailored coefficient of thermal expansion interface layer directly sintered to the mounting surface of the metal injection molded base plate and forming a mounting surface for mounting IGBT modules.

8. Base plate apparatus as claimed in claim 1 wherein the thermal expansion interface layer includes a single monolithic layer.

9. Base plate apparatus as claimed in claim 1 wherein the thermal expansion interface layer includes a plurality of layers graduated in coefficient of thermal expansion values from a high value in contact with the base plate to a low value at the mounting surface for mounting IGBT modules.

10. Base plate apparatus as claimed in claim 9 wherein the base plate is constructed of a powdered metal and at least one thermal expansion interface layer is constructed of a powdered metal.

11. Base plate apparatus as claimed in claim 1 wherein the thermal expansion interface layer includes an aggregate of cells.

12. Base plate apparatus as claimed in claim 11 wherein each cell in the aggregate of cells are selected to have an xy dimension that lies in a range of approximately 1x1 mm to approximately 10x10 mm.

13. Base plate apparatus as claimed in claim 12 wherein spacing between cells in the aggregate of cells ranges from approximately 200 micrometers to approximately 1000 micrometers.

14. Base plate apparatus as claimed in claim 1 wherein the base plate is formed of copper.

15. Base plate apparatus as claimed in claim 1 wherein the base plate includes a depression in the mounting surface defining the bounds of the thermal expansion interface layer and the thermal expansion interface layer is formed in the depression and directly bonded to the mounting surface of the copper base plate in the depression.
